Europäisches Patentamt

European Patent Office

Office européen des brevets

(11) Publication number: **0 197 228**
**B1**

(12) EUROPEAN PATENT SPECIFICATION

(45) Date of publication of patent specification: **27.06.90**

(51) Int. Cl.⁵: **G 11 C 7/00, H 03 F 3/72**

(21) Application number: **85400679.8**

(22) Date of filing: **05.04.85**

(54) Circuit and method for split bias enable/inhibit memory operation.

(43) Date of publication of application:
**15.10.86 Bulletin 86/42**

(45) Publication of the grant of the patent:
**27.06.90 Bulletin 90/26**

(84) Designated Contracting States:
**DE FR GB IT NL**

(56) References cited:
**FR-A-1 583 362**
**US-A-3 466 562**
**US-A-3 737 797**
**US-A-3 775 557**

(73) Proprietor: **FAIRCHILD SEMICONDUCTOR CORPORATION**
**10400 Ridgeview Court P.O. Box 1500**
**Cupertino, California 95014 (US)**

(72) Inventor: **Santos, Joe**
**3275 Withers Avenue**
**Lafayette California 94549 (US)**

(74) Representative: **Sparing Röhl Henseler**
**Patentanwälte European Patent Attorneys**
**Rethelstrasse 123**
**D-4000 Düsseldorf 1 (DE)**

Courier Press, Leamington Spa, England.

**Description**

Background of the invention
1. Field of the invention

The present invention relates to a circuit and method for selectively enabling and disabling a split differential amplifier. More particularly, the present invention relates to a circuit and method for combining the functions of signal amplifying, buffering, and output enabling in a memory device by use of split bias enabling.

2. Description of the prior art

Circuits and techniques for communicating the contents of a solid state memory to other devices are well known. Such circuits receive a differential input, indicative of memory cell contents at an associated memory location, and produce a corresponding logic level output signal. A memory select or output enable/inhibit feature is typically included with such circuits. Accordingly, an output signal is produced only when required and as selected.

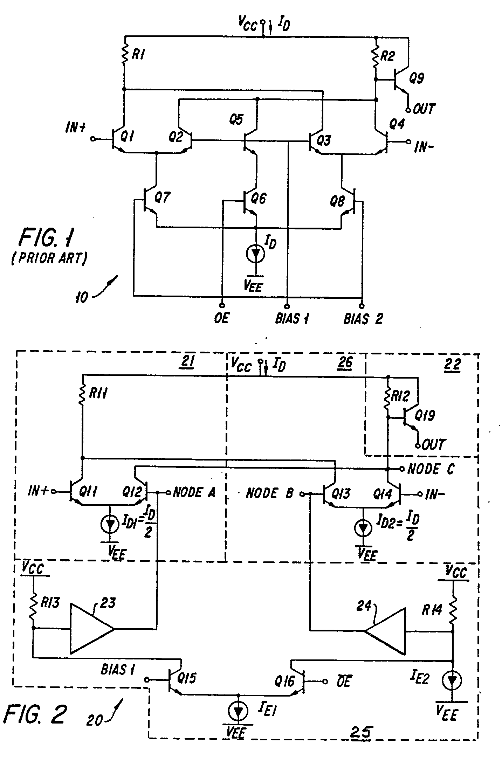

Fig. 1 shows a prior art differential amplifier circuit 10, which consists of transistors Q1—Q4 and resistors R1 and R2. A logic high or low output signal is produced at transistor Q9; output enable/inhibit is controlled by transistors Q5—Q8.

In operation, if the memory cell contents to be transferred by circuit 10 are a logic high, a logic high signal IN+ is present at the base of transistor Q1 and a logic low signal IN− is present at the base of transistor Q4. As a result, a current $I_D$ is steered through resistor R1 and thereafter through each of transistors Q1 and Q3. Current $I_D$ is split at the collectors of transistors Q1 and Q3. A current $I_D/2$ flows through each of transistors Q1 and Q3 and, thereafter, through transistors Q7 and Q8, respectively.

No voltage drop is developed across resistor R2 as a result of steering current $I_D$ through transistors Q1 and Q3. The voltage is coupled to the base of transistor Q9, turning transistor Q9 on, and producing a logic high output signal at the emitter of transistor Q9.

If the memory contents transferred by circuit 10 are a logic low, a logic low input signal is present at the base of transistor Q1, and a logic high signal is present at the base of transistor Q4. As a result, current $I_D$ is steered through resistor R2 and thereafter through each of transistors Q2 and Q4; current $I_D/2$ flows through each of transistors Q2 and Q4 and thereafter, through transistors Q7 and Q8, respectively. The voltage drop developed across resistor R2 and coupled to the base of transistor Q9 turns transistor Q9 off because current $I_D$ is now steered through resistor R2 and transistors Q2 and Q4. Therefore, a logic low output signal is produced at the emitter of transistor Q9.

A BIAS 1 signal, present at the base of transistors Q2, Q3, and Q5, sets a voltage level relative to which input signal IN+ must be more positive and relative to which input signal IN− must be more negative if circuit 10 is to produce a logic high output signal at the emitter of transistor Q9. BIAS 1 signal also sets the voltage level relative to which input signal IN+ must be more negative and relative to which input signal IN− must be more positive if circuit 10 is to produce a logic low output at the emitter of transistor Q9.

A second BIAS signal—BIAS 2—is coupled to the base of transistors Q7 and Q8 to establish an output enable voltage level. An output enable signal $\overline{OE}$ is coupled to the base of transistor Q6. Circuit 10 is operated when output signal $\overline{OE}$ is a logic low relative to the BIAS 2 signal. When output enable signal $\overline{OE}$ is a logic high relative to the BIAS 2 signal, transistor Q6 conducts and steers current $I_D$ through transistors Q5 and Q6 through resistor R2 producing a voltage drop across resistor R2. As a result, a logic low output signal is produced at the emitter of transistor Q9, without regard to logic input signals IN+ and IN−.

When the circuit is enabled, differential amplifier pairs consisting of transistors Q1 and Q2, and Q3 and Q4 are operative as follows:

|  | Reading a "1" | Reading a "0" |
| --- | --- | --- |
| IN+ (base Q1) | high relative to Bias 1 | low relative to Bias 1 |
| IN(−) (base Q4) | low relative to Bias 1 | high relative to Bias 1 |
| Q1 | On | Off |
| Q2 | Off | On |
| Q3 | On | Off |
| Q4 | Off | On |
| I thru $R_2$ | Ø | $\sim I_D$ |

When disabled, transistors Q7 and Q8 are off and transistor Q6 is on. The transistor Q1, Q2 and transistor Q3, Q4 differential amplifiers are not operative as follows:

| | | Disabled | Enabled |
|---|---|---|---|
| Q1 Q2 Q3 Q4 | Inoperative no emitter current Q7, Q8 are off | Depends on logic state at input IN+ IN− (see above) | |
| Q5 | | On | Off |
| Q6 | | On | Off |
| Q7 | | Off | On |
| Q8 | | Off | On |

One disadvantage of such prior art circuits is the need to provide a current path through transistors Q7 and Q8. Such transistors must be, of necessity, large in size to steer current $I_D$ (which may be on the order of 6 milliamperes). Such large transistors slow circuit response time by increasing circuit parasitic capacitance. Precise current steering also is inhibited by transistors Q7 and Q8, unless identical matched transistors are used to balance the transistor's steering of current $I_D$.

The additional functional elements required by prior art enabling circuits increase both space and power requirements, while substantially slowing circuit response time. These limitations are particularly noticeable in high speed electronic devices, such as solid state memory circuits.

Summary of the invention

The present invention combines the functions of signal amplifying, buffering, and output enabling. The invention consists of a differential amplifier stage, an output stage, and an enable/inhibit stage. The differential amplifier stage includes two differential transistor pairs coupled to steer a current $I_D$ along one of two selected current paths. When operated in conjunction with a solid state memory circuit, the differential amplifying stage controls the output stage to produce an output logic signal that corresponds to a differential logic input signal.

The differential transistor pairs each include an input terminal that is coupled to detect a logic high signal IN+ or a logic low signal IN−, respectively. Current $I_D$ is steered along one of the two current paths in response to the logic signal level detected by the differential transistor pairs. Output stage operation is a function of current $I_D$ flow along one of the two selected current paths.

The enable/inhibit stage maintains balanced bias signal on a control terminal portion of each of the differential transistor pairs to enable circuit operation. Circuit operation is inhibited when the bias signal is split or unbalanced. In such condition, current $I_D$ is continually steered along a corresponding logic low current path. This produces a continual logic low output signal that remains unaffected by varying input conditions at the differential transistor pairs.

Accordingly, the present invention as claimed in apparatus claim 1 and method claim 6 provides a split bias current steering circuit that, when enabled, provides a selected logic output signal corresponding to a differential logic input signal. Current flow in the circuit is evenly divided between two active devices, e.g., one transistor "leg" of each of the two differential transistor pairs. As a result, the required power handling capacity of the active devices in the circuit may be significantly reduced without affecting circuit operation or reliability. The size of the circuit functional elements, such as the differential transistors, is accordingly reduced, as is the space necessary to integrate the circuit onto a monolithic substrate (or to lay out the circuit on a printed circuit board if discrete devices are used).

The number of functional elements required to implement the present invention also is significantly reduced. This reduction in circuit overhead and the small size of the functional elements used in the circuit, significantly reduces parasitic capacitance and current loading. As a result, extremely fast circuit response time is advantageously provided by the present invention. The invention's fast response time makes it particularly useful in memory circuits where rapid and reliable data transfer is critical.

Brief description of the drawings

Fig. 1 is a schematic diagram of a prior art memory enable/inhibit circuit; and

Fig. 2 is a schematic diagram of an exemplary split bias enable/inhibit circuit according to the present invention.

Detailed description of a preferred embodiment

A schematic diagram of an exemplary embodiment of the invention, a split bias enable/inhibit circuit 20, is shown in Fig. 2. The invention combines the functions of signal amplifying, buffering, and output signal enable/inhibit. Although the preferred embodiment of the invention incorporates a split differential amplifier, it should be appreciated that the present invention can also provide enable/inhibit control of standard differential amplifier circuits.

In the embodiment of the invention shown in Fig. 2, three circuit stages are provided: a differential amplifier pair input stage 21 and 26, an output stage 22, and an enable/inhibit stage 25. The differential amplifier pair input stage 21 and 26 includes differential transistor pairs Q11 and Q12, and Q13 and Q14. The differential transistor pairs are arranged to form two parallel paths for routing current $I_D$, $I_{D1}$, and $I_{D2}$ to current sink $V_{EE}$. The collectors of transistors Q11 and Q13 are coupled to current source $I_D$ through resistor R11 and the collectors of transistors Q12 and Q14 are coupled to current source $I_D$ through resistor R12. This arrangement establishes a first current path through transistors Q11 and Q13 by which a current $I_D/2$ may be conducted through each of transistors Q11 and Q13; and it establishes an alternate current path through transistors Q12 and Q14 by which current $I_D/2$ may be conducted through each of transistors Q12 and Q14.

Output stage 22 includes a transistor Q19 having a collector and base terminal coupled across a resistor R12. An output signal is developed at the emitter of transistor Q9 in accordance with a voltage at its base, established at a circuit node C.

Enable/inhibit stage 25 may be of any type of circuit that provides a selectable balanced/unbalanced (split) bias signal at circuit nodes A and B. The enable/inhibit stage includes a buffer amplifier 23 and 24 coupled to circuit nodes A and B, respectively. Buffer amplifiers 23 and 24 are controlled by transistors Q15 and Q16.

Transistors Q15 and Q16 comprise a differential amplifier. Bias 1 is connected to the base of transistor Q15 and the output enable signal $\overline{OE}$ is connected to the base of transistor Q16. When $\overline{OE}$ is low relative to Bias 1, the output is enabled and transistor Q15 is on and transistor Q16 is off. Current $I_{E1}$ flows through transistor Q15 and resistor R13. Current $I_{E2}$ flows through resistor R14. Currents $I_{E1}$ and $I_{E2}$, and resistors R13 and R14 are chosen so that the voltage drop across resistor R13 is the same as the voltage drop across resistor R14 to force the voltage at node A to be equal to the voltage at node B, between the high and low levels at the bases of transistors Q11 and Q13.

When $\overline{OE}$ is high relative to Bias 1, the output is disabled, and transistor Q15 is off and transistor Q16 is on. Current $I_{E1}$ flows through transistor Q16 and resistor R14; current $I_{E2}$ also flows through resistor R14. Currents $I_{E1}$ and $I_{E2}$, and resistors R13 and R14 are chosen so that the voltage drop across resistor R14 is sufficient to force node B lower than the lowest low level at the base of transistor Q14. Transistor Q14 is not always on, steering current $I_{D2}=I_D/2$ out of node C. Voltage $V_{CC}$ and IN+, coupled to the base of transistor Q11, are chosen so that the voltage at node A is always high relative to the voltage at IN+. Transistor Q12 is always on, steering current $I_{D1}=I_D/2$ out of node C.

The combination of currents $I_{D1}$ and $I_{D2}$ generate sufficient voltage drop across resistor R12 so that the voltage at node C is low and the output is low.

As an example of circuit operation assume that the contents of a memory cell, are a logic high. Accordingly, a logic high signal is present at the base of transistor Q11 (IN+) and a logic low signal is present at the base of transistor Q14 (IN−). Transistor Q11 conducts, allowing current $I_D$ to flow through resistor R11. Current $I_D$ is split evenly between transistors Q11 and Q13—each of the transistors conducts a current $I_D/2$. Neither of the transistors need be large enough to conduct the entire current $I_D$. Accordingly, the transistors may be smaller in size to resultingly exhibit a faster response time, due to a reduction in the parasitic capacitance associated with larger sized devices.

When logic high signal IN+ is positive relative to node A and IN− is negative relative to node B, current $I_D$ is drawn away from resistor R12. Because there is no current flow through transistors Q12 and Q14, no voltage drop is developed across resistor R12. The $V_{CC}$ voltage is coupled to the base of transistor Q19, turning the transistor on, and a high output signal is produced at the emitter of transistor Q19. In this way, logic high memory contents are coupled through the circuit, amplified as necessary (by the transistor pairs), and buffered.

When a logic low is stored in a corresponding memory cell, IN− is positive relative to node B and IN+ is negative relative to node A, turning transistors Q12 and Q14 on and routing current $I_D$ through resistor R12. Thereafter, current $I_D$ is split by transistors Q12 and Q14 such that each transistor conducts a current $I_D/2$. Because under these conditions a constant current flows through resistor R12 and transistors Q12 and Q14, there is a voltage drop across resistor R12. Accordingly, a low signal is developed at the base of transistor Q19. The transistor therefore remains turned off and no signal is produced at the emitter of transistor Q19. This condition corresponds to a logic low output signal. In this way, logic low memory contents are coupled through the circuit.

4

When enabled, the voltages at node A and node B are chosen so that node A is between the high and low level at IN+ and node B is between the high and low levels at IN−, as follows:

| | Enabled | | Disabled | |
| --- | --- | --- | --- | --- |
| | Read 1 | Read 0 | Read 1 | Read 0 |
| Q11 | On | Off | Off | Off |
| Q12 | Off | On | On | On |
| Q13 | On | Off | Off | Off |
| Q14 | Off | On | On | On |
| I thru R12 | 0 | $\sim I_D$ | $\sim I_D$ | $\sim I_D$ |
| IN+ (Q11 base) | High Relative A | Low Relative A | Low Relative A | Low Relative A |
| IN− (Q14 base) | Low Relative B | High Relative B | High Relative B | High Relative B |
| Node A | Med. | Med. | High | High |
| Node B | Med. | Med. | Low | Low |

Accordingly, the present invention provides signal amplifying, buffering, and output enable/inhibit by use of split biasing with a differential transistor pair circuit. Current is steered to provide a logic output signal in accordance with a logic input signal when circuit operation is enabled. Circuit output is held at a constant level without regard to the circuit input signal level when circuit operation is inhibited. Because the enable/inhibit circuit is also used to bias the differential amplifier stages in both the enabled and inhibited modes, a standby current is not required and standby power loss is reduced.

The present circuit operates efficiently with a low voltage power supply, for instance, in a battery operated device operating on weak batteries, because there are few gating transistors in series that would affect circuit operation. The present invention substantially reduces layout area by reducing the number of high current carrying transistors and by reducing the size of each transistor proportional to the amount of current it must carry. Such advantageous results are the effect of splitting the driving current evenly through one leg of each transistor pair along the selected current path. Accordingly, any number of differential amplifiers can be controlled by the enable/inhibit circuitry, as for example, in memory devices having several controlled memory cells.

One advantage of the present invention is the novel control of several differential stages by a single enable stage. For example, in memory device, all the memory cells in a particular row or column may be enabled simultaneously by a single enable circuit. Thus, a differential transistor pair is associated with each memory cell; several differential transistor pairs are coupled in parallel at circuit nodes A and B for control by enable/inhibit stage 25.

The reduction in component size and in the number of components required also eliminates the requirement of complex biasing signals for multiple stage amplifiers. By reducing current carrying requirements, parasitic capacitance is significantly reduced and circuit response is radically improved. The present invention may be operated in a memory device such as a bipolar static RAM at speeds as fast as five nanoseconds. Such high speed memories readily find application in many electronic devices, such as microcircuit testing devices where test vectors are rapidly moved through the tester and into the tested device.

The foregoing was given for purposes of illustration and example. It will be appreciated by those skilled in the art that the present invention is readily practiced in various equivalent applications and embodiments. For example, the enable/inhibit stage may be modified as desired, the only requirement being that the bias signal provided to circuit nodes A and B be balanced to enable circuit operation and be split to inhibit circuit operation. Additionally, the present invention may find application in devices other than solid state memory devices. For example, the invention may be used to control differential amplifiers. Therefore, the scope of the invention should be limited only by the breadth of the claims.

5

# EP 0 197 228 B1

**Claims**

1. A memory enable/inhibit circuit, comprising:

a first differential amplifier (21) having an input terminal (IN+) coupled to receive a first logic input signal and being operable to steer a current along a first current path in response to said first logic input signal, and having a first bias terminal (node A) receiving a first bias signal,

a second differential amplifier (26) having an input terminal (IN−) coupled to receive a second logic input signal and being operable to steer said current along a second current path in response to said second logic input signal, and having a second bias terminal (node B) receiving a second bias signal, and

output means (22) having a control terminal coupled to a node (node C) along said second current path, for producing a first logic output signal when said current is steered along the one of said current paths and for producing a second logic output signal when said current is steered along the other of said current paths,

characterized by further comprising:

enable/inhibit means (25), coupled to said first and second bias terminals (node A, node B) for producing said first and second bias signals, wherein circuit operation is enabled when said first and second bias signals are balanced, i.e. equal, in that said first and second current paths may readily be selected in response to said corresponding first and second logic input signals (IN+, IN−), and wherein circuit operation is inhibited when said first and second bias signals are split, i.e. not equal, in that a predetermined current path is continuously selected without regard to said first and second logic input signals.

2. The circuit of claim 1, characterized in that said enable/inhibit means includes:

a first bias source (R13, 23) coupled to said first bias terminal (node A), for providing said first bias signal thereto,

a second bias source (R14, 24) coupled to said second bias terminal (node B), for providing said second bias signal thereto; and

means (Q15, Q16) coupled to said first and second bias sources, for selectably operating said bias sources to produce said balanced first and second bias signals when circuit operation is enabled and to produce said split first and second bias signals when circuit operation is inhibited.

3. The circuit of claim 2 characterized in that said means for selectably operating said bias sources comprises:

a differential transistor pair (Q15, Q16) coupled to receive an output enable signal (OE) to operate said first and second bias sources to selectably provide said balanced first and second bias signals when said output enable signal (OE) is in a first logic state and to provide said split first and second bias signals when said output enable signal (OE) is in a second logic state.

4. The circuit of any one of claims 1 to 3, characterized in that said first differential amplifier (21) includes:

a) a first transistor (Q11) having a first terminal coupled to a current source, a second terminal coupled to a current sink, and a control terminal coupled to receive said first logic input signal (IN+), and

b) a second transistor (Q12) having a first terminal coupled to said current source, a second terminal coupled to said current sink, and a control terminal coupled to said first bias terminal (node A),

and in that said second differential amplifier (26) includes:

a) a third transistor (Q13) having a first terminal coupled to said current source, a second terminal coupled to said current sink, and a control terminal coupled to said second bias terminal (node B), and

b) a fourth transistor (Q14) having a first terminal coupled to said current source, a second terminal coupled to said current sink, and a control terminal coupled to receive said second logic input signal (IN−).

5. The circuit of claim 4, characterized in that said output means (22) includes a fifth transistor (Q19) having a first terminal coupled to said current source, a control terminal coupled to said second and fourth transistors (Q12, Q14), and a second terminal (OUT) coupled to provide said first logic output signal when current is steered along one of said current paths and to provide said second logic output signal when current is steered along the other of said current paths.

6. A method for enabling and disabling circuit operation in a memory circuit including a first differential transistor pair (Q11, Q12) having an input terminal coupled to receive a first logic input signal (IN+) and being operable to steer a current along a first current path in response to said first logic input signal, having a second differential transistor pair (Q13, Q14) having a second input terminal coupled to receive a second logic input signal (IN−) and being operable to steer a current along a second current path in response to said second logic input signal, and having an output stage (22) operable to produce a first logic output signal and a second logic output signal in response to the one of said corresponding first and second selected current paths along which current is steered, said method being characterized by comprising:

providing a first bias signal to a first bias terminal (node A) of said first differential transitor pair (Q11, Q12) and a second bias signal to a second bias terminal (node B) of said second differential transistor pair (Q13, Q14), whereby circuit operation is enabled when said first and second bias signals are balanced, i.e. equal, in that said first and second current paths may readily be selected in response to said corresponding first and second logic input signals (IN+, IN−), and

whereby circuit operation is inhibited, when said first and second bias signals are split, i.e. not equal, in

6

that a predetermined current path is continuously selected without regard to said first and second logic input signals (N+, N−).

**Patentansprüche**

1. Eine Speicher-Entsperr/Sperr-Schaltung, umfassend:

einen ersten Differentialverstärker (21) mit einem Eingangsanschluß (IN+), angekoppelt zum Empfang eines ersten Logikeingangssignals und betreibbar zum Steuern eines Stroms längs eines ersten Strompfads im Ansprechen auf das genannte erste Logikeingangssignal, und mit einem ersten Vorspannanschluß (Knoten A), der ein erstes Vorspannsignal empfängt,

einen zweiten Differentialverstärker (26) mit einem Eingangsanschluß (IN−), angekopellt zum Empfang eines zweiten Logikeingangssignals und betreibbar zum Steuern das genannten Stroms längs eines zweiten Strompfads im Ansprechen auf das genannte zweite Logikeingangssignal, und mit einem zweiten Vorspannanschluß (Knoten B), der ein zweites Vorspannsignal empfängt, und

Ausgangsmittel (22) mit einem Steueranschluß, angekoppelt an einen Knoten (Knoten C) längs des genannten zweiten Strompfads für das Erzeugen eines ersten Logikausgangssignals, wenn der genannte Strom längs des einen der genannten Strompfade gesteuert wird, und zum Erzeugen eines zweiten Logikausgangssignals, wenn der genannte Strom längs des andern der genannten Strompfade gesteuert wird,

dadurch gekennzeichnet, daß sie ferner umfaßt:

Entsperr/Sperr-Mittel (25), angekoppelt an die genannten ersten und zweiten Vorspannanschlüsse (Knoten A, Knoten B) zum Erzeugen der genannten ersten und zweiten Vorspannsignale, wobei der Schaltungsbetrieb entsperrt wird, wenn die genannten ersten und zweiten Vorspannsignale ausbalanziert, das heißt gleich, sind, daß die genannten ersten und zweiten Strompfade ohne weiteres auswählbar sind im Ansprechen auf die genannten entsprechenden ersten und zweiten Logikeingangssignale (IN+, IN−), und wobei der Schaltungsbetrieb gesperrt ist, wenn die genannten ersten und zweiten Vorspannsignale gespalten, d.h. ungleich, sind, daß ein vorbestimmter Strompfad continuierlich ausgewählt wird ohne Rücksicht auf die genannten ersten und zweiten Logikeingangssignale.

2. Die Schaltung nach Anspruch 1, dadurch gekennzeichnet, daß die Entsperr/Sperr-Mittel umfassen:

eine erste Vorspannquelle (R13, 23), angekoppelt an den genannten ersten Vorspannanschluß (Knoten A) für das Bereitstellen des genannten ersten Vorspannsignals an ihm,

eine zweite Vorspannquelle (R14, 24), angekoppelt an den genannten zweiten Vorspannanschluß (Knoten B), zum Bereitstellen des genannten zweiten Vorspannsignals an ihm, und

Mittel (Q15, Q16), angekoppelt an die genannten ersten und zweiten Vorspannquellen zum wahlweisen Betrieben der genannten Vorspannquellen zur Erzeugung des genannten ausbalanzierten ersten und zweiten Vorspannsignals, wenn der Schaltungsbetrieb entsperrt ist, und zur Erzeugung der genannten gespaltenen ersten und zweiten Vorspannsignale, wenn der Schaltungsbetrieb gesperrt ist.

3. Die Schaltung nach Anspruch 2, dadurch gekennzeichnet, daß die genannten Mittel für das wahlweise Betreiben der genannten Vorspannquellen umfassen:

ein Differentialtransistorpaar (Q15, Q16), angekoppelt zum Empfang eines Ausgangsentsperrsignals (OE) zum Betreiben der ersten und zweiten Vorspannquellen für das wahlweise Bereitstellen der genannten ausbalanzierten ersten und zweiten Vorspannsignale, wenn das genannte Ausgangsentsperrsignal (OE) in einem ersten Logikzustand ist, und das Bereitstellen der genannten gespaltenen ersten und zweiten Vorspannsignale, wenn das genannte Ausgangsentsperrsignal (OE) in einem zweiten Logikzustand ist.

4. Die Schaltung nach einem der Ansprüche 1 bis 3, dadurch gekennzeichnet, daß der genannte erste Differentialverstärker (21) umfaßt:

a) einen ersten Transistor (Q11) mit einem ersten Anschluß, angekoppelt an eine Stromquelle, mit einem zweiten Anschluß, angekoppelt an eine Stromsenke, und einem Steueranschluß, angekoppelt zum Empfang des genannten ersten Logikeingangssignals (IN+), und

b) einen zweiten Transistor (Q12) mit einem ersten Anschluß, angekoppelt an die genannte Stromquelle, mit einem zweiten Anschluß, angekoppelt an die genannte Stromsenke, und einem Steueranschluß, angekoppelt an den genannten ersten Vorspannanschluß (Knoten A),

und daß der genannte zweite Differentialverstärker (26) umfaßt:

a) einen dritten Transistor (Q13) mit einem ersten Anschluß, angekoppelt an die genannte Stromquelle, mit einem zweiten Anschluß, angekoppelt an die genannte Stromsenke, und einem Steueranschluß, angekoppelt an den genannten zweiten Vorspannanschluß (Knoten B), und

b) einen vierten Transistor (Q14) mit einem ersten Anschluß, angekoppelt an die genannte Stromquelle, mit einem zweiten Anschluß, angekoppelt an die genannte Stromsenke, und einem Steueranschluß angekoppelt zum Empfang des genannten zweiten Logikeingangssignals (IN−).

5. Die Schaltung nach Anspruch 4, dadurch gekennzeichnet, daß die genannten Ausgangsmittel (22) einen fünften Transistor (Q19) umfassen mit einem ersten, an die Stromquelle angekoppelten Anschluß, einem an den zweiten und vierten Transistor (Q12, Q14) angekoppelten steueranschluß, und einem zweiten Anschluß (OUT), angekoppelt zum Bereitstellen des genannten ersten Logikausgangssignals, wenn Strom längs eines der genannten Strompfade gesteuert wird, und zum Bereitstellen des genannten zweiten Logikausgangssignals, wenn Strom längs des andern der genannten Strompfade gesteuert wird.

**EP 0 197 228 B1**

6. Ein Verfahren zum Entsperren und Sperren von Schaltungsbetrieb in einer Speicherschaltung, umfassend ein erstes Differentialtransistorpaar (Q11, Q12) mit einem Eingangsanschluß, angekoppelt zum Empfang eines ersten Logikeingangssignals (IN+) und betreibbar zum Steuern eines Stroms längs eines ersten Strompfads im Ansprechen auf das gennante erste Logikeingangssignal, ein zweites Differentialtransistorpaar (Q13, Q14) mit einem zweiten Eingangsanschluß, angekoppelt zum Empfang eines zweiten Logikeingangssignals (IN−) und betriebbar zum Steuern eines Stroms längs eines zweiten Strompfads im Ansprechen auf das genannte zweite Logikeingangssignal, sowie eine Ausgangsstufe (22), betreibbar zum Erzeugen eines ersten Logikausgangssignals und eines zweiten Logikausgangssignals im Ansprechen auf denjenigen der genannten entsprechenden ersten und zweiten ausgewählten Strompfade, längs dem Strom gesteuert wird, welches Verfahren dadurch gekennzeichnet ist, daß es umfaßt:

Bereitstellen eines ersten Vorspannsignals an einem ersten Vorspannanschluß (Knoten A) des genannten ersten Differentialtransistorpaars (Q11, Q12) und eines zweiten Vorspannsignals an einem zweiten Vorspannanschluß (Knoten B) des genannten zweiten Differentialtransistorpaares (Q13, Q14), wodurch der Schaltungsbetrieb entsperrt wird, wenn die ersten und zweiten Vorspannsignale ausbalanziert, d.h. gleich, sind, daß die genannten ersten und zweiten Strompfade ohne weiteres auswählbar sind im Ansprechen auf die entsprechenden ersten und zweiten Logikeingangssignale (IN+, IN−), und

wodurch der Schaltungsbetrieb gesperrt wird, wenn die genannten ersten und zweiten Vorspannsignale gespalten, d.h. ungleich, sind, daß ein vorbestimmter Strompfad kontinuierlich ausgewählt ist ohne Rücksicht auf die genannten ersten und zweiten Logikeingangssignale (IN+, IN−).

**Revendications**

1. Circuit d'activation/de désactivation de mémoire comprenant

un premier amplificateur différentiel (21) ayant une borne d'entrée (IN+) reliée de façon à recevoir un premier signal d'entrée logique et étant apte à diriger un courant le long d'un premier trajet de courant en réponse audit signal d'entrée logique, et ayant une première borne de polarisation (noeud A), recevant un premier signal de polarisation,

un second amplificateur différentiel (26) ayant une borne d'entrée (IN−) reliée de façon à recevoir un second signal d'entrée logique et étant apte à diriger ledit courant le long d'un second trajet de courant en réponse audit second signal d'entrée logique, et ayant une seconde borne de polarisation (noeud B) recevant un second signal de polarisation, et

des moyens de sortie (22) ayant une borne de commande reliée à un noeud (noeud C) le long dudit second trajet de courant pour produire un premier signal de sortie logique quand ledit courant est dirigé le long d'un desdits trajets de courant et pour produire un second signal de sortie logique quand ledit courant est dirigé le long de l'autre desdits trajets de courant,

caractérisé en ce qu'il comporte en outre:

des moyens d'activation/de désactivation (25), reliés auxdites première et seconde bornes de polarisation (noeud A, noeud B) pour produire lesdits premier et second signaux de polarisation, dans lesquels le fonctionnement du circuit est activé quand lesdits premier et second signaux de polarisation sont équilibrés c'est-à-dire égaux, en ce que lesdits premier et second trajets de courant peuvent être facilement sélectionnés en réponse auxdits premier et second signal d'entrée logique correspondants (IN+, IN−) et dans lequel le fonctionnement du circuit est désactivé quand lesdits premier et second signaux de polarisation sont divisés c'est-à-dire non égaux en ce qu'un trajet de courant prédéterminé est continuellement sélectionné indépendamment des premier et second signaux d'entrée logique.

2. Circuit selon la revendication 1 caractérisé en ce que les moyens d'activation/de désactivation comprennent:

une première source de polarisation (R13, 23) reliée à ladite première borne de polarisation (noeud A) pour lui fournir ledit premier signal de polarisation,

une seconde source de polarisation (R14, 24) reliée à ladite seconde borne de polarisation (noeud B) pour lui fournir ledit second signal de polarisation; et

des moyens (Q15, Q16) reliés auxdites première et seconde sources de polarisation pour mettre en fonction de façon sélectionnable lesdites sources de polarisation pour produire lesdits premier et second signaux de polarisation équilibrés quand le fonctionnement du circuit est activé et pour produire lesdits premier et second signaux de polarisations divisés quand le fonctionnement du circuit est désactivé.

3. Circuit selon la revendication 2 caractérisé en ce que lesdits moyens pour mettre en fonction de façon sélectionnable lesdites sources de polarisation comprennent:

une paire de transistors différentiels (Q15, Q16) reliés de façon à recevoir un signal d'activation de sortie (OE) pour mettre en fonction lesdites première et seconde sources de polarisation pour fournir de façon sélectionnable lesdits premier et second signaux de polarisation équilibrés quand ledit signal d'activation de sortie (OE) est dans un premier état logique et pour fournir lesdits premier et second signaux de polarisation divisés quand ledit signal d'activation de sortie (OE) est dans un second état logique.

4. Circuit selon l'une quelconque des revendications 1 à 3 caractérisé en ce que ledit premier amplificateur différentiel (21) comprend:

a) un premier transistor (Q11) ayant une première borne reliée à une source de courant, une seconde borne reliée à un puits de courant et une borne de commande reliée de façon à recevoir ledit premier signal d'entrée logique (IN+) et

b) un second transitor (Q12) ayant une première borne reliée à ladite source de courant, une seconde borne reliée audit puits de courant, et une borne de commande reliée à ladite première borne de polarisation (noeud A),

et en ce que ledit second amplificateur différentiel (26) comprend:

a) un troisième transistor (Q13) ayant une première borne reliée à ladite source de courant, une seconde borne reliée audit puits de courant, et une borne de commande reliée à ladite seconde borne de polarisation (noued B) et

b) un quatrième transistor (Q14) ayant une première borne reliée à ladite source de courant, une seconde borne reliée audit puits de courant et une borne de commande reliée de façon à recevoir ledit second signal d'entrée logique (IN−).

5. Circuit selon la revendication 4 caractérisé en ce que lesdits moyens de sortie (22) comprennent un cinquième transistor (Q19) ayant une première borne reliée à ladite source de courant, une borne de commande reliée auxdits deuxième et quatrième transistors (Q12, Q14) et une seconde borne (OUT) reliée de façon à fournir ledit premier signal de sortie logique quand le courant est dirigé le long d'un desdits trajets de courant et pour fournir ledit second signal de sortie logique quand le courant est dirigé le long de l'autre desdits trajets de courant.

6. Procédé pour activer et désactiver le fonctionnement d'un circuit dans un circuit de mémoire comprenant une première paire de transistors différentiels (Q11, Q12) ayant une borne d'entrée reliée de façon à recevoir un premier signal d'entrée logique (IN+) et apte à diriger un courant le long d'un premier trajet de courant en réponse audit premier signal d'entrée logique, ayant une seconde paire de transistors différentiels (Q13, Q14) ayant une seconde borne d'entrée reliée de façon à recevoir un second signal d'entrée logique (IN−) et étant apte à diriger un courant le long d'un second trajet de courant en réponse audit second signal d'entrée logique et ayant un étage de sortie (22) apte à produire un premier signal de sortie logique et un second signal de sortie logique en réponse à l'un desdits premier et second trajets de courant sélectionné correspondants le long duquel le courant est dirigé, ledit procéde étant caractérisé en ce qu'il comprend:

la fourniture d'un premier signal de polarisation à une première borne de polarisation (noeud A) de ladite première paire de transistors différentiel (Q11, Q12) et un second signal de polarisation à une seconde borne de polarisation (noeud B) de ladite seconde paire de transistors différentiels (Q13, Q14), le fonctionnement du circuit étant activé quand lesdits premier et second signaux de polarisation sont équilibrés c'est-à-dire égaux, en ce que lesdits premier et second trajets de courant peuvent aisément être sélectionnés en réponse auxdits premier et second signaux d'entrée logique correspondants (IN+, IN−) et en ce que le fonctionnement du circuit est désactivé quand lesdits premier et second signaux de polarisation sont divisés c'est-à-dire non égaux, en ce qu'un trajet de courant prédéterminé est continuellement sélectionné indépendamment desdits premier et second signaux d'entrée logique (IN+, IN−).

$V_{CC}$ | $I_D$

R1

R2

Q9

OUT

IN+

Q1

Q2

Q5

Q3

Q4

IN-

Q7

Q6

Q8

$I_D$

$V_{EE}$

FIG. 1

(PRIOR ART)

10

OE

BIAS 1

BIAS 2

21

$V_{CC}$ | $I_D$

26

22

R11

R12

Q19

OUT

NODE C

IN+

Q11

Q12

NODE A

NODE B

Q13

Q14

IN-

$I_{D1} = \frac{I_D}{2}$

$V_{EE}$

$I_{D2} = \frac{I_D}{2}$

$V_{EE}$

$V_{CC}$

$V_{CC}$

R13

23

24

R14

BIAS 1

Q15

Q16

OE

$I_{E2}$

$V_{EE}$

FIG. 2

20

$I_{E1}$

$V_{EE}$

25